# EUROPEAN PATENT SPECIFICATION

(11) **EP 2 567 404 B1**
(45) Date of publication and mention of the grant of the patent: **12.07.2017**
(21) Application number: 11722569.8
(22) Date of filing: 02.05.2011
(51) Int. Cl.: H01L 29/778, H01L 29/423, H01L 27/088

(54) **FIELD EFFECT POWER TRANSISTORS**
FELDEFFEKT-LEISTUNGSTRANSISTOREN
TRANSISTORS DE PUISSANCE À EFFET DE CHAMP

(30) Priority: 02.05.2010 US 330361 P
(43) Date of publication of application: 13.03.2013
(73) Proprietor: Visic Technologies Ltd., Nes Ziona, 7403650 (IL)
(72) Inventor: BUNIN, Gregory, 77510 Ashdod (IL); BAKSHT, Tamara, 69101 Tel Aviv (IL); ROZMAN, David, 77536 Ashdod (IL)
(74) Representative: Pearl Cohen Zedek Latzer Baratz UK LLP
(86) International application number: PCT/IB2011/051939
(87) International publication number: WO 2011/138732

(56) References cited:
- WO-A1-2009/119357
- US-A1- 2004 130 037
- US-A1- 2007 034 969
- US-A1- 2009 072 269
- US-A1- 2009 146 185
- US-A1- 2009 166 678
- US-A1- 2010 025 730
- US-A1- 2010 084 688
- MIZUTANI T ET AL: "AlGaN/GaN HEMTs With Thin InGaN Cap Layer for Normally Off Operation", IEEE ELECTRON DEVICE LETTERS, IEEE SERVICE CENTER, NEW YORK, NY, US, vol. 28, no. 7, 1 July 2007 (2007-07-01), pages 549-551, XP011186078, ISSN: 0741-3106, DOI: DOI:10.1109/LED.2007.900202
- ITO M ET AL: "Normally-off AlGaN/GaN HEMTs with thin InGaN cap layer", IEICE TRANSACTIONS ON ELECTRONICS, INSTITUTE OF ELECTRONICS, TOKYO, JP, vol. E91C, no. 7, 1 July 2008 (2008-07-01) , pages 989-993, XP001515443, ISSN: 0916-8524, DOI: DOI:10.1093/IETELE/E91-C.7.989

## Description

### RELATED APPLICATIONS

### TECHNICAL FIELD

Embodiments of the invention relate to field effect transistors.

### BACKGROUND

Various products and systems, including consumer products such as TVs, electric powered vehicles, radar systems, electric motor controllers and uninterrupted power supply (UPS) systems, require provision of relatively large amounts of electric power often provided from a high voltage power supply. Various types of semiconductor field effect transistors (FETs) based on silicon materials and technology are generally used as power switches to perform switching functions required by the products and systems.

A FET typically comprises terminals referred to as a "source" and a "drain" for connecting a power source to a load and a terminal in the FET located between the source and drain referred to as a "gate" for controlling resistance of a current carrying channel in the FET located under the gate between the source and drain. Voltage relative to a common ground voltage applied to the gate generates an electric field in the FET that controls the resistance of the channel to turn the transistor ON and OFF. When turned ON, voltage applied the gate reduces the resistance of the channel to allow relatively large current flow between the source and drain. Total resistance between the source and drain when the transistor is turned ON is referred to as an "ON resistance" of the transistor. The ON resistance depends upon the resistance of the channel, resistance to current flow of a region of the FET under, and in the neighborhood, of the source, and resistance of a region of the FET under, and in the neighborhood, of the drain. The regions under and in the neighborhoods of the source and drain are conventionally referred to as access regions.

Whereas conventional power FETs based on Si provide useful switching functions, they are not readily configured to provide desired characteristics for power switching applications for, by way of example, operation of devices such as, electric motors and vehicles, uninterruptable power supplies (UPS) and photovoltaic inverters. Switches suitable for operation of these devices are advantageously characterized by relatively high breakdown voltage when they are OFF, high "ON currents" between source and drain when they are ON, and relatively low gate and drain leakage currents. It is advantageous that they are capable of operating at high junction temperatures and that they exhibit good tolerance to current and/or voltage transients that tend to occur during switching between OFF and ON states. In addition, for safety reasons, preferably the switches are OFF when their gates are at ground potential.

For example, it can be advantageous for a semiconductor power switch to have a breakdown voltage equal to or greater than about 600 V and drain leakage currents less than about 100µA per mm (millimeter) of gate periphery when OFF. When ON it is advantageous that the switch, have an ON resistance less than or about equal to 10 Ohm per mm and be capable of safely supporting a drain current greater than or equal to about 50 A (amps). In addition, for safety reasons, it is generally advantageous that the switch be OFF for gate voltages less than about 2 volts, and be able to operate without damage to itself at junction temperatures greater than or equal to about 200° C. Semiconductor switches based on Si materials and technology are generally not readily configurable to provide these specifications because their band gaps, which are typically less than about 2 eV (electron volts), and saturation drift velocities of electrons in the materials do not naturally support high breakdown voltages and large ON current.

Nitride based semiconductor materials, such as GaN (Gallium Nitride) and A1N (Aluminum Nitiride) on the other hand, are characterized by relatively large band gaps of 3.4 eV and 6.2 eV respectively. And FETs having a nitride semiconductor layer structure comprising a small band gap layer adjacent a large band gap layer provide a relatively high concentration of high mobility electrons characterized by a high saturation drift velocity. The high mobility electrons accumulate in a narrow triangular potential well at an interface between the layers to form a relatively thin, sheet-like electron concentration, referred to as two dimensional electron gas (2DEG). Because of the geometrical construction and location of the 2DEG, electrons in the 2DEG generally evidence very low donor impurity scattering, and as a result, the relatively high electron mobility, which may for example be equal to about 1.5 x 10⁷ cm/s. Concentrations of electrons in a 2DEG may be as high as 1 x 10¹³/cm².

FET transistors that operate by generating and controlling high mobility electrons in 2DEGs are conventionally referred to as high electron mobility transistors "HEMTs". Semiconductor layer structures comprising layers of different composition that characterize these transistors are referred to as "heterostructures", and interfaces between two adjacent layers of different composition are referred to as "heterojunctions".

Whereas the inherent characteristics of nitride based semiconductor materials appear to make them excellent materials for use in producing high power semiconductor switches, it has proven difficult to exploit the characteristics to provide such switches. For example, 2DEG nitride FETs are normally ON, rather than being the desired, normally OFF, and it has been found difficult to produce nitride semiconductor layers having defect concentrations sufficiently low to produce power FETs having desired characteristics at acceptable costs.

US 2009/0146185 A1 discloses a GaN based normally off HEMT with recessed insulated gate.

### J SUMMARY

An embodiment of the invention relates to providing a FET comprising a plurality of nitride semiconductor layers for which piezoelectric and spontaneous polarization of the layers are configured so that the FET is normally OFF and has a relatively large breakdown voltage, and when ON, has relatively small resistance to current flow between a source and drain of the transistor.

In the invention, the layers in the FET comprise a 2DEG current channel located in a relatively narrow band gap nitride "channel" layer, in a neighborhood of a heterojunction between the channel layer and a relatively wide band gap nitride layer. The wide band gap layer functions as an "electron supply", layer, which provides electrons to the channel layer. The channel and electron supply layers are associated with a third nitride layer, referred to as a "potential modifying layer". In an embodiment of the invention, an electric field generated by piezoelectric and/or spontaneous polarization of the potential modifying layer has a direction opposite to that in the electron supply layer. The electric field of the potential modifying layer modifies an electrostatic potential generated by electrostatic fields resulting from polarization of the channel and electron supply layers to substantially depopulate the 2DEG channel in the first current channel of electrons so that the FET is normally OFF.

In an embodiment of the invention, the channel and electron supply layers associated with the first 2DEG channel are formed from GaN and In_{y}Al_{z}Ga_{1-y-z}N respectively. The potential modifying layer is formed optionally from InₓGa₁₋ₓN. To mitigate impurity scattering that reduces electron mobility, optionally, the semiconductor materials in the channel and electron supply layers in the FET are not intentionally doped.

In accordance with the invention, the FET comprises additional 2DEG current channels at heterojunctions of other nitride layers that have 2DEGs in access regions of the FET. The additional 2DEG channels and electrons in the access regions enable establishment of a relatively small resistance current path between the source and drain when the FET is turned ON.

A plurality of gates are located between the source and drain, and voltages applied to the gates are used to shape fields in the FET that control currents and electron concentrations in the 2DEG current channels. Optionally, the FET is formed having a recess or recesses that have bottom surfaces at different depths below a top layer of the FET. Different gates of the plurality of gates are located on different bottom surfaces of the recess or recesses.

In an embodiment of the invention, to turn the FET ON voltages that decrease monotonically with distance of the gates from the source are applied to the gates to generate or enhance electron populations in 2DEGs in the plurality of 2DEG channel layers. Optionally, the voltages are configured to moderate current and/or voltage transients in the FET that may appear and damage the FET during transition of the FET from OFF to ON.

In an embodiment of the invention, layers in the FET comprising the channel and electron supply layers are epitaxially grown over a superlattice structure of thin semiconductor layers that is epitaxially embedded in a buffer layer and doped with compensation impurities. The superlattice structure operates to moderate propagation of dislocations, pipes and other defects from the substrate into the channel and electron supply layers that would tend to reduce electron concentration and mobility of electrons in the channel layers and enhance leakage currents in the FET. The compensation impurities provide the superlattice with increased resistance to current flow.

In an embodiment of the invention, conducting material for source and drain electrodes is deposited only on a top semiconductor surface of the FET prior to annealing to provide ohmic contact between the source and drain electrodes and current carrying, "active", channel layers of the FET. By limiting deposits of the conducting material for the electrodes to the top layer, distance between the deposits and semiconductor layers below the active layers is maximized. As a result, during annealing, diffusion of conducting material from the deposits to the layers below the active layers is moderated. Moderating diffusion of conducting material to layers below the active layers operates to reduce leakage currents.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

### BRIEF DESCRIPTION OF FIGURES

Non-limiting examples of embodiments of the invention are described below with reference to figures attached hereto that are listed following this paragraph. Identical structures, elements or parts that appear in more than one figure are generally labeled with a same numeral in all the figures in which they appear. Dimensions of components and features shown in the figures are chosen for convenience and clarity of presentation and are not necessarily shown to scale.
Fig. 1A schematically shows a perspective view of a normally OFF FET, optionally comprising three 2DEG channels and three gates, in an OFF state, in accordance with an embodiment of the invention;
Fig. 1B schematically shows providing a FET with ohmic contact source and drain electrodes in which diffusion of conducting material penetrates to a buffer layer in the FET;
Fig. 1C schematically show providing the FET shown in Fig. 1B with ohmic contact source and drain electrodes in which diffusion of conducting material is prevented from penetrating to the buffer layer in the FET, in accordance with an embodiment of the invention;
Fig. 1D shows band diagrams for regions of the FET shown in Fig. 1A for the OFF state, in accordance with an embodiment of the invention;
Fig. 2A schematically shows the FET shown in Fig. 1A in an ON state, in accordance with an embodiment of the invention;
Fig. 2B schematically shows energy band diagrams for the FET in the ON state shown in Fig. 2A, in accordance with an embodiment of the invention;
Fig. 3 schematically shows a FET similar to that shown in Figs. 1A and 2A and comprising a negatively charged dielectric layer under gates of the FET, in accordance with an embodiment of the invention;
Figs. 4A and 4B schematically show a monolithic array of FETs similar to that shown in Fig. 1A configured in a checkerboard pattern, in accordance with an embodiment of the invention;
Fig. 4C schematically shows a cross section of a portion of the FET array shown in Fig. 4B having sources electrically connected by a metal pad and drains connected by a different metal pad electrically isolated from the source pad, in accordance with an embodiment of the invention;
Fig. 4D schematically shows a chip comprising a checkerboard array of FET and mounted to a chip carrier, in accordance with an embodiment of the invention; and
Fig. 5 schematically shows a cross section of an array of FETs housed in a heat dissipating housing in accordance with an embodiment of the invention.

### DETAILED DESCRIPTION

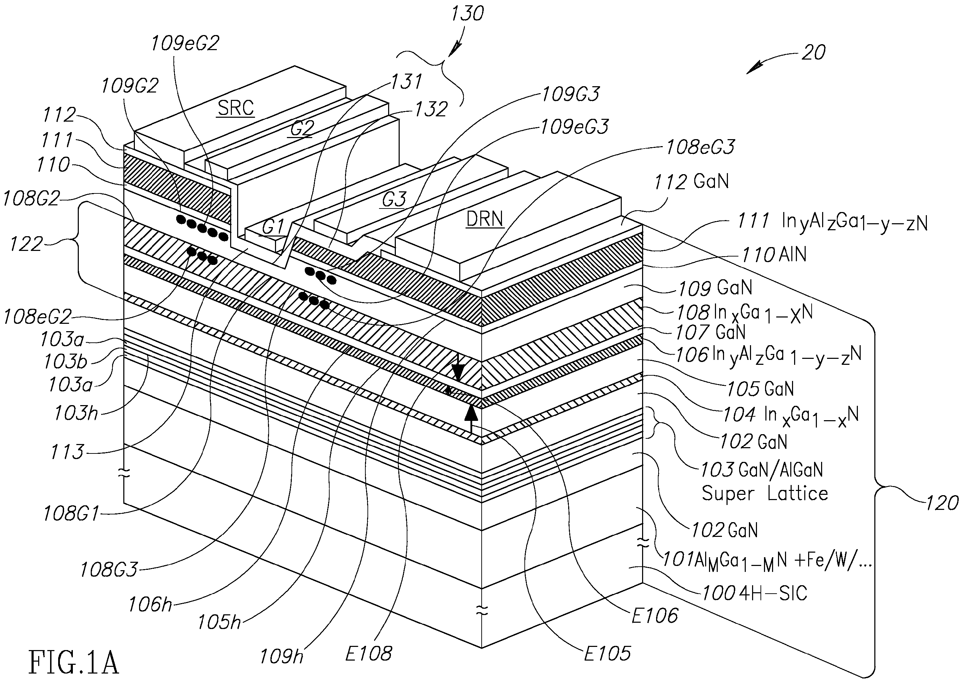

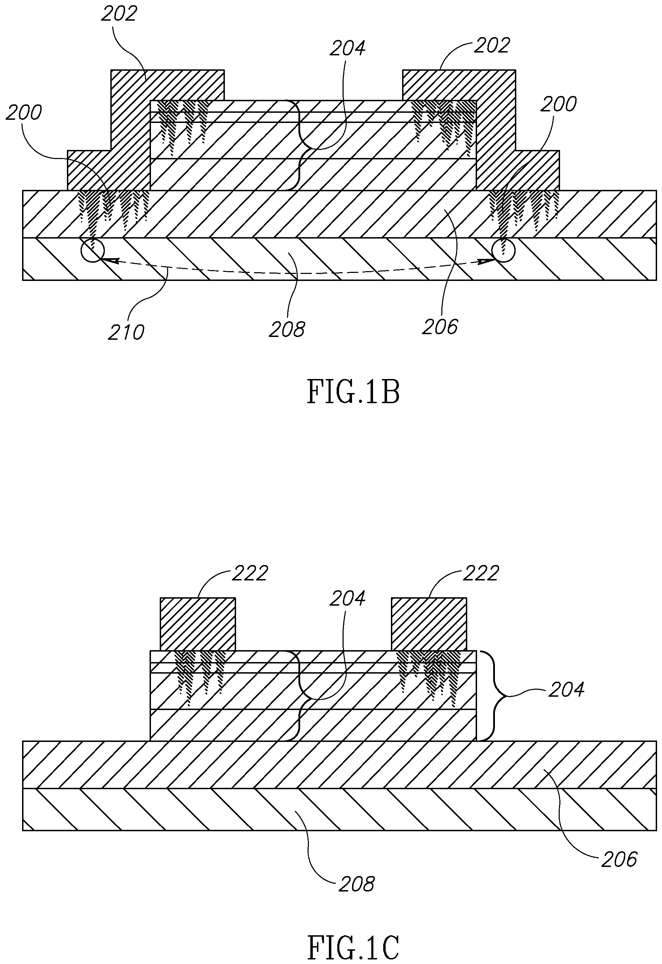

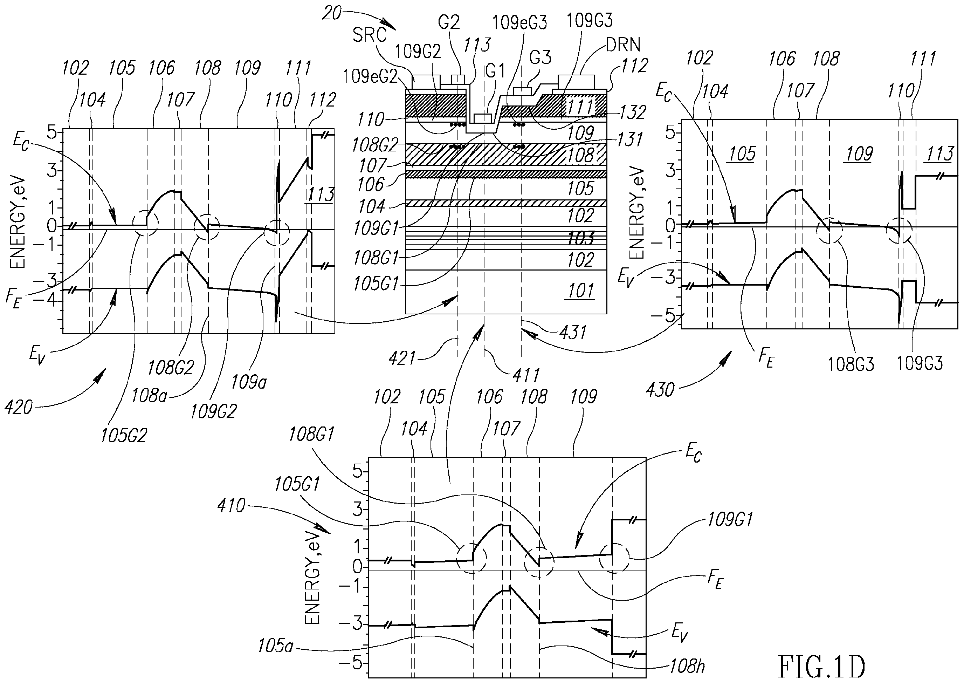

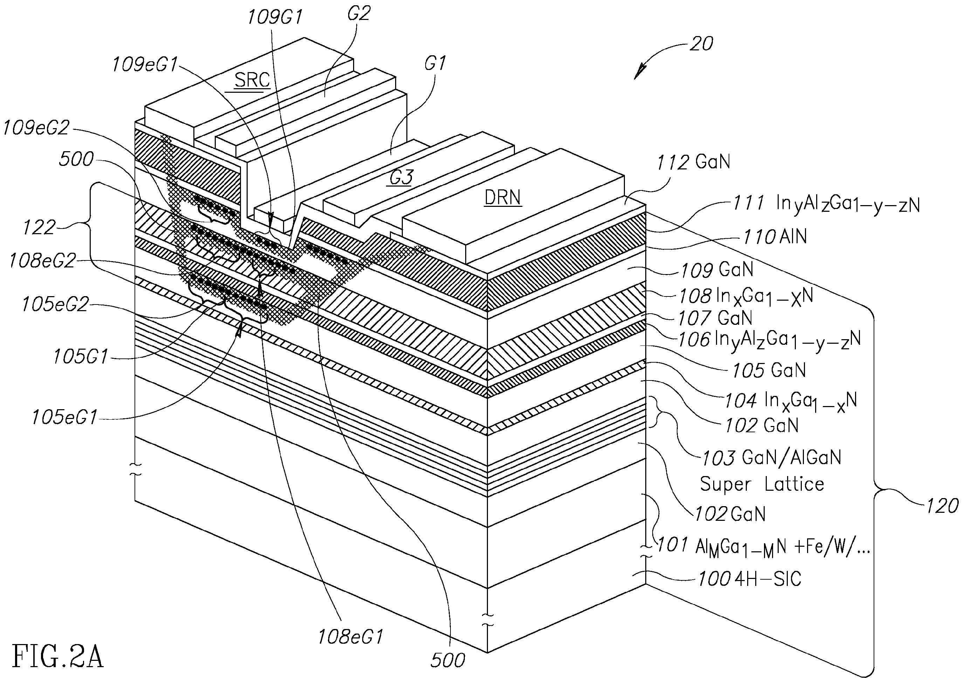

In the following paragraphs of the detailed description, structure of a power FET in accordance with an embodiment of the invention and characteristics of 2DEG concentrations in layers of the FET for OFF states are discussed with reference to Fig. 1. Methods for providing a semiconductor device, such as the FET shown in Fig. 1A, with electrodes that tend to reduce leakage currents in the device are discussed with reference to Figs. 1B and 1C. Band diagrams for the OFF state of the FET are shown in Fig. 1D and are discussed with reference to the figures. Fig. 2A schematically shows the FET shown in Fig. 1A when the FET is ON. Band diagrams for the ON state of the FET are shown in Fig. 1D and are discussed with reference to the figures.

In the discussion unless otherwise stated, adjectives such as "substantially" and "about" modifying a condition or relationship characteristic of a feature or features of an embodiment of the invention, are understood to mean that the condition or characteristic is defined to within tolerances that are acceptable for operation of the embodiment for an application for which it is intended.

Fig. 1A schematically shows a perspective view of a normally OFF, GaN FET transistor 20 comprising a drain "DRN", a source "SRC" and, optionally three gates, G1, G2 and G3 located between the source and drain, formed on a heterostructure stack 120 of epitaxially grown semiconductor layers, in accordance with an embodiment of the invention. The semiconductor layers have 2DEG current paths for conducting current between source SRC and drain DRN. Application of appropriate voltages to the gates controls the current paths to be conducting and non-conducting and the FET correspondingly ON and OFF. In Fig. 1A it is assumed that no voltages are applied to the gates and the FET is OFF.

Stack 120 comprises a bottom, optionally high resistance substrate layer 100 on which overlaying layers are epitaxially formed, optionally by a metal organic chemical vapor deposition (MOCVD) growth process. In some embodiments of the invention the layers are grown by a molecular beam epitaxy (MBE) growth process. Substrate 100 may comprise a single crystal Si, Al₂O₃ (Sapphire), A1N, or a single crystal polytype of SiC (silicon carbide, carborundum) such as 4H-SiC, 6H-SiC, or 3C-SiC.

A high resistance Al_{M}Ga_{1-M}N layer buffer layer 101 is grown on the substrate. Buffer layer 101 operates to reduce occurrence of threading and other dislocations in upper layers of stack 120, which may be generated by lattice mismatch between substrate 100 and the upper layers. Layer 101 is optionally doped with Fe, W, V, Cr, Ni or Mg to decrease concentration of conduction band electrons in the layer material and enhance the layer's resistance to leakage currents in the transistor that may flow through the layer. Layer 101 has a thickness between about 0.5 and about 5 µm (microns) and M between 0.0 and about 0.05.

A GaN layer 102 having embedded therein a GaN/AlGaN superlattice 103 is formed over layer 101. GaN layer 102 has thickness between about 200 nm and about 400 nm. Optionally, GaN layer 102 has thickness equal to about 300 nm. Superlattice 103 comprises a plurality of GaN layers 103a interleaved with Al_{L}Ga_{1-L}N layers 103b. In an embodiment of the invention, superlattice 103 comprises at least 10 alternating GaN/Al_{L}Ga_{1-L}N layers 103a/103b. Each layer 103a or 103b in the superlattice has thickness between about 1 nm and about 30 nm. Interfaces, that is heterojunctions, 103h between the superlattice layers 103a and 103b operate as "mechanical" barriers that moderate propagation of dislocations from layers 100 and 101 into epitaxial layers in stack 120 above layer 102. Layer 102 comprising superlattice 103 in accordance with an embodiment of the invention may be considered an additional buffer layer that reduces defect concentrations in active layers located above layer 102, which are controlled to carry current between source SRC and drain DRN. Layers 102 and 103 are optionally doped with Fe, W V, Cr, Ni or Mg to increase resistance of the layers to current flow.

An active layer set 122 of epitaxial layers comprising a normally OFF, non-conducting, 2DEG current channel is grown on layer 102. In an embodiment of the invention, active layer set 122 comprises a relatively narrow band, GaN channel layer 105 contiguous with a relatively wide band In_{y}Al_{z}Ga_{1-y-z}N electron supply layer 106. The 2DEG current channel is located in GaN layer 105 close to an interface, that is, a heterojunction 105h between the GaN and In_{y}Al_{z}Ga_{1-y-z}N layers 105 and 106.

Discontinuity between conduction and valence bands in GaN layer 105 and conduction and valence bands respectively in In_{y}Al_{z}Ga_{1-y-z}N layer 106, and electrostatic fields generated by piezoelectric and spontaneous polarization in the layers would normally produce a triangular potential well in the GaN layer near heterojunction 105h and populate the potential well with a 2DEG. The electrostatic fields in layers 105 and 106 are schematically represented by block arrows labeled E₁₀₅ and E₁₀₆ respectively. The 2DEG would make the current channel in GaN layer 105 conducting and able to support current flow between source SRC and drain DRN when no voltages are applied to gates G1, G2 and G3, and result in FET 20 being normally ON.

However, in accordance with an embodiment of the invention, active layer set 122 comprises a potential modifying layer 108, having an electrostatic field represented by a block arrow E₁₀₈ generated by spontaneous and/or piezoelectric polarization of the layer that has a direction opposite to the electrostatic field E₁₀₆ in electron supply layer 106. Optionally, layer 108 comprises InₓGa₁₋ₓN. Electric field E₁₀₈ generates a potential that operates to reduce a depth of a triangular potential well that might be generated at heterojunction 105h and reduce a number of electrons that might accumulate in the well to create a 2DEG at the heterojunction. Potential modifying layer 108 therefore results in the current channel in GaN layer 105 being normally depopulated of electrons and non-conducting, and FET 20 therefore normally OFF.

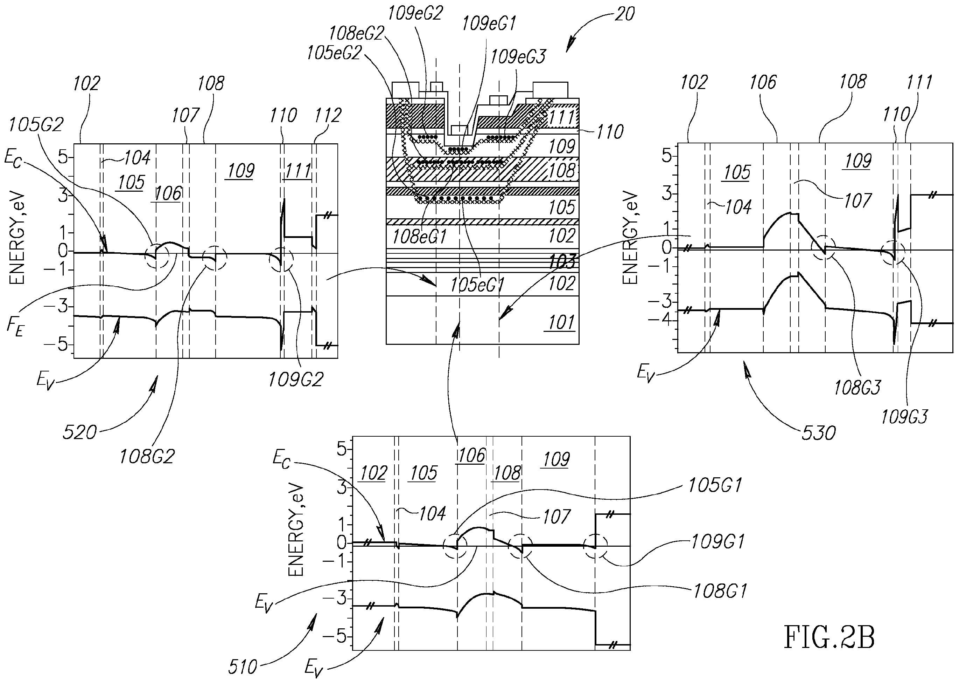

In an embodiment of the invention, active layer set 122 comprises an InₓGa₁₋ₓN layer 104 formed on layer 103 that functions as a barrier layer to improve confinement of electrons to layer 105 when, as discussed below with reference to Figs. 2A and 2B, FET 20 is controlled to be ON and current flows in layer 105. Concentration "x" in layer 104 has a value between about 0.05 and about 0.1 and the layer has thickness between about 1 nm and about 2 nm. Optionally, active layer set 122 comprises a GaN transition layer 107 located between layers 106 and 108. Layer 107 operates to enhance lattice matching between layer 106 and layer 108 and layers above layer 108.

In an embodiment of the invention, GaN channel layer 105 has thickness between about 5 nm and about 20 nm. Optionally, In_{y}Al_{z}Ga_{1-y-z}N electron supply layer 106 has thickness between about 8 nm and about 12 nm and has a graded Al mole fraction, which decreases from a about 0.35 at heterojunction 105h with layer 105 to about 0.05 at a heterojunction 106h between layers 106 and 107. In an embodiment of the invention, to match lattices in channel layer 105 and electron supply layer 106, y is equal to about 0.176 and z is equal to about 4.66y. InₓGa₁₋ₓN potential modifying layer 108 has thickness between about 3 nm and 20 nm and x has a value between about 0.08 and about 0.22.

A second GaN channel layer 109 and associated In_{y}Al_{z}Ga_{1-y-z}N electron supply layer 111 separated by an AlN spacer layer 110 are formed on layer 108. AlN spacer 110 functions to reduce alloy scattering of electrons at a heterojunction 109h and increase electron mobility and density in 2DEGs formed near regions 109G2 and 109G3 of the heterojunction. The 2DEGs are discussed below. Layer 109 has thickness between about 1 nm and about 27 nm. Layer 111 has thickness between about 8 nm and about 13 nm before formation of recess 130 discussed below. AlN spacer layer has thickness between about 0.5 nm and about 3 nm. Optionally, as in the case of layers 105 and 106, to match lattices in GaN channel layer 109 and electron supply layer 111, y is equal to about 0.176 and z is equal to about 4.66y. A GaN cap layer 112 having thickness between about 0.5 nm and about 4 nm protects surface regions of layer 111 under and in vicinities of drain DRN and source SRC from being oxidized.

Source and drain terminals SRC and DRN located on cap layer 112 comprise ohmic contact metal stack deposits that are subjected to an annealing process so that metal in the terminals diffuses into underlying active semiconductor layers to promote formation of an ohmic contact between each terminal and the semiconductor layers.

Metal deposits for conventional ohmic contact terminals are typically formed so that they contact vertical edges of active layers in a mesa of a semiconductor device to which ohmic contact is desired and contact a buffer layer on which the upper epitaxial layers of the mesa is grown. During annealing, diffusion of the metal in the conventional deposits tends to form sharp tipped metallic, "stalactites" that penetrate the buffer layer. Penetration of the stalactites into the buffer layer, and strong electrostatic fields generated by their sharp tips promote leakage currents and tend to damage the buffer and other layers in the mesa.

In accordance with an embodiment of the invention, to prevent formation of metallic stalactites that penetrate to the buffer layer, metallic deposits for source SRC and drain DRN are deposited only on top, GaN cap layer 112 of FET 20 and are prevented from contact with vertical edges of stack 120.

Fig. 1B schematically shows formation of stalactites 200 resulting from a conventional production process of ohmic contact terminals 202 for a mesa 204 of semiconductor layers grown on a buffer layer 206. The stalactites penetrate the buffer layer and generate intense electric fields at their relatively sharp tips and edges, which fields tend to promote leakage currents in the buffer layer and in an underlying substrate layer 208. A leakage current path between sharp points (circled for ease of reference) of the stalactites is schematically indicated by a dashed arrow head line 210.

Fig. 1C schematically shows formation of stalactites 220 in a production process of an ohmic contact terminal 222 for the same mesa 204 of semiconductor layers shown in Fig. 1B, in accordance with an embodiment of the invention. Because metal for terminals 222 is deposited only on a top layer 205 of mesa 204, and not deposited on edges of layers in the mesa or on buffer layer 206, the stalactites do not penetrate the buffer layer.

In an embodiment of the invention, FET 20 is formed having a terraced recess 130, shown in Fig. 1A comprising lower and upper terraces 131 and 132 located respectively in In_{y}Al_{z}Ga_{1-y-z}N layer 111 and GaN layer 109. A layer 113 of insulting insulating material, such as Si₃N₄, AL₂O₃, or AlN, covers surfaces of recess 130 and surface regions of layer 111 along edges of the recess. Gate G1 is located on insulating layer 113 that covers lower terrace 131 and gate G3 is located on a portion of insulating layer 113 that covers upper terrace 132. Gate G2 is located adjacent source SRC on a portion of insulating layer 113 that covers In_{y}Al_{z}Ga_{1-y-z}N layer 111.

In a region of FET 20 under gate G2, GaN channel layer 109, AlN spacer layer 110 and In_{y}Al_{z}Ga_{1-y-z}N electron supply layer 111 are "intact", that is their thickness, has not been altered by recess 130. Energy differences between the conduction and valence bands in GaN channel layer 109 and the conduction and valence bands respectively in In_{y}Al_{z}Ga_{1-y-z}N layer 111, and electrostatic electric fields generated by polarization in the layers produce a triangular potential well in the GaN layer near a heterojunction region 109G2 and populate the potential well with a 2DEG. In Fig.1A electrons in the 2DEG are schematically represented by filled circles 109eG2, which numeral is also used to refer to the 2DEG. In an embodiment of the invention 2DEG 109eG2 has an electron concentration equal to or greater than about 10¹³ electrons per cm². The potential well is schematically shown in energy band diagrams in Fig. 1D discussed below.

In a region of FET 20 under gate G3, GaN channel layer 109 and AlN spacer layer 110 are intact, but In_{y}Al_{z}Ga_{1-y-z}N electron supply layer 111 is thinned down under gate G3 to between about 20% to about 70% of its width under gate G2 by formation of recess 130. As in heterojunction region 109G2, energy differences between conduction and valence bands in layer 109 and conduction and valence bands in layer 111 and electrostatic fields in the layers populate a 2DEG at a region 109G3 heterojunction of heterojunction 109h between layers 109 and 110. Electrons in the 2DEG, and the 2DEG, are schematically represented by filled circles 109eG3. However, because the region of electron supply layer 111 under gate G3 is thinner than the region of electron supply layer 111 under G2, 2DEG 109eG3 under G3 has a smaller accumulation of electrons than 2DEG 109eG2 under gate G2. To schematically indicate the relative sizes of the 2DEGs under gates G2 and G3, a number of electrons 109eG3 shown in layer 109 under gate G3 is smaller than a number of electrons 109eG2 shown in layer 109 under gate G2. In an embodiment of the invention 2DEG 109eG3 has an electron concentration equal to or greater than about 3x10¹² electrons per cm².

Recess 130 has resulted in complete removal of electron supply layer 111 and spacer layer 110 under gate G1. Therefore, in the absence of voltage on gate G1, a 2DEG does not exist under gate G1, and as a result no continuous conductive path capable of carrying current between source SRC and drain DRN exists in layer 109. Nor does a 2DEG exist under gate G1 in any layers of active layer set 122 and therefore the active layer set does not provide a continuous conductive current path between source SRC and drain DRN in the absence of voltage on gate G1.

As discussed above, active layer set 122 is absent any 2DEGs because of the functioning, in accordance with an embodiment of the invention, of potential modifying layer 108, in preventing generation of a 2DEG in GaN channel layer 105. Potential wells (schematically shown in Fig. 1D) capable of accumulating 2DEG electrons exist in layer 108 along heterojunction regions 108G1, 108G2 and 108G3 between layers 108 and 109, under gates G1, G2 and G3 respectively. Potential wells under gates G2 and G3 are populated with electrons 108eG2 under gate G2 and electrons 108eG3 under gate G3. However, the potential well in the current band edge under gate G1, as shown in Fig. 1D has energy substantially greater than the Fermi energy and therefore is substantially without electrons. Layer 108 therefore does not provide a conducting current path between source SRC and drain DRN in the absence of voltage applied to gate G1.

As a result, as shown for FET 20 in Fig. 1A, in the absence of appropriate voltages on gate G1, and gates G2 and G3, continuous conduction paths in the FET between source SRC and drain DRN are substantially non-existent, and the FET is OFF.

Fig. 1D shows a schematic cross section of FET 20 and graphs 410, 420 and 430 that show energy band diagrams associated with regions of the FET under gates G1, G2 and G3 respectively. Dashed lines 411, 421 and 431 indicate regions of FET under gates G1, G2, and G3 characterized by the band diagrams in graphs 410, 420 and 430 respectively. Regions in the graphs corresponding to semiconductor layers shown in Fig. 1A are labeled with the same numerals with which they are labeled in Fig. 1A. Vertical dashed lines in the graphs indicate heterojunctions between the layers. Regions of the heterojunctions in the graphs associated with regions of heterojunctions in Fig. 1A are indicated by dashed circles labeled with the numerals with which the regions of the heterojunctions are labeled in Fig. 1A. Potential energy is shown along an ordinate of each graph and a line E_{F} indicates the Fermi energy level for each band diagram. Lines E_{C} and E_{V} in a graph delineate conduction and valence band edges respectively for the region of FET 20 associated with the graph.

By way of a numerical example, the energy bands shown in graphs 410, 420 and 430 are determined for thickness of layers 102, 103, ... to 108 equal respectively to 1800 nm, 150 nm, 1 nm, 10 nm, 10 nm, 2.6 nm, and 10 nm respectively. Under gates G2 and G3 layer 109 is assumed to have thickness of 25 nm and under gate G1 thickness of 5 nm. Under gate G2, layers 110, 111 and 112 are assumed to have thickness of 1 nm, 10.7 nm and 1.5 nm respectively. Under gate G3 layers 110 and 111 have thickness of 1 nm and 5 nm respectively. Dielectric layer 113 has thickness equal to 20 nm.

In graph 410, which shows conduction and valence band edges E_{C} and E_{V} for the region of FET 20 under gate G1, conduction band edge E_{C} is displaced above the Fermi energy E_{F}. As a result, the conduction band, and a potential well in a region indicated by a dashed circle 108G1, of the heterojunction between layers 108 and 109 are relatively empty of electrons. It is noted that in regions of heterojunctions layers 105 and 106 and between layers 109 and 110 indicated by dashed circles 105G1 and 109G1 respectively in graph 410, depth of lower terrace 131 (Fig. 1), and differences in conduction band and valence band energy levels of layers 105-109 substantially eliminate potential wells capable of accumulating 2DEG electrons. The absence of any concentration of 2DEG electrons under gate G1 renders FET 20 OFF when no voltages are applied to gate G1.

Under G2, as shown in graph 420 on the other hand, electron potential wells exist in regions of heterojunctions between layers 108 and 109 and between layers 109 and 110 indicated respectively by dashed circles 108G2 and 109G2 in the graph, and portions of the potential wells are located below the Fermi energy E_{F}. Similarly, electron potential wells under gate G3 exist in regions of heterojunctions between layers 108 and 109 and between layers 109 and 110 indicated by dashed circles 108G3 and 109G3 respectively in graph 430, and portions of these potential wells are located below the Fermi level E_{F}. As a result, the potential wells in the regions indicated by the dashed circles are at least partially filled with 2DEG electrons.

The 2DEGs under gates G2, and electrons in the potential wells that populate the 2DEGs are, as noted above in the discussion of Fig. 1A, schematically represented respectively by filled circles 109eG2 and 108eG2. Similarly, the 2DEGs under gates G3, and electrons in the potential wells that populate the 2DEGs are, as noted above in the discussion of Fig. 1A, schematically represented respectively by filled circles 109eG2 and 108eG2.

The regions under gates G2 and G3 are, as noted above, referred to as access regions and the 2DEGs 109eG2, 109eG2, 108eG3, and 108eG3 in the access regions provide sources of electrons for rapidly filling electron channels under gate G1 and establishing continuous, low resistance conduction current paths between source SRC and drain DRN when FET 20 is turned ON.

Voltages applied to gates G1, G2, and G3 operate to generate electric fields in FET 20 that change current paths in the FET between source SRC and drain DRN from substantially non-conducting, high resistance current paths, to conducting, low resistance current paths and turn the FET ON, in accordance with an embodiment of the invention. The plurality of gates allows voltages applied to the gates to be configured to shape fields and electrostatic potential in the FET that provide advantageous characteristics for operation of the FET. For example, voltages applied to the gates may be used to moderate potentially damaging large voltage and/or current transients in the FET during transition between ON and OFF states.

It is noted that whereas FET 20 comprises three gates, practice of the invention is not limited to three gates. For example, a FET transistor may have four or more gates located between a source and a drain to generate a desired shape electrostatic potential in the FET.

In an embodiment of the invention, voltage applied to a gate closer to source SRC to turn FET 20 ON is larger than voltage applied to a gate farther from the source. The decreasing voltage regime moderates large swings in voltage and/or current during transition periods between ON and OFF states of FET 20. In symbols, if voltages applied to gates G1, G2, and G3 to turn FET 20 ON are represented by V1, V2, and V3 respectively, then the voltages may have a relationship V2 > V1 > V3.

For a configuration of a normally OFF FET, such as FET 20, in accordance with an embodiment of the invention, voltages V1 and V2 applied to gates G1 and G2 to turn ON the FET are positive. In an embodiment of the invention, V1 is greater than or equal to about 2.0 volts. Optionally V1 is greater than or equal to about 2.5 volts. In an embodiment of the invention V2 is greater than or equal to about 2.5 volts. Optionally, V2 is greater than or equal to about 3 volts. In an embodiment of the invention V3 is less than or equal to about 0 volts. Optionally V3 is less than or equal to about -1 volt.

Fig. 2A schematically shows a perspective view of FET 20 when the FET is turned ON by voltages V1, V2, and V3. Fig. 2B schematically shows a cross section view of FET 20 in the ON state shown in Fig. 2A. Fig. 2B also shows graphs 520, 530 of energy bands E_{C} and E_{V} for access regions of FET 20 under gates G2 and G3 respectively, and a graph 510 of energy bands E_{C} and E_{V} for a region of the FET under gate G1. Regions of heterojunctions distinguished by labeled dashed circles in the graphs shown in Fig. 1D are distinguished by dashed circles respectively labeled by the same numerals in the graphs of Fig. 2B.

By way of a numerical example, the energy bands in graphs 510, 520 and 530 are determined for thickness of layers which are the same as those used to determine the energy band shown in graphs 410, 420, and 430, and V1, V2, and V3, equal respectively to about 2.5 volts, 3 volts, and -1 volt.

Positive voltage V1 applied to gate G1 reconfigures the conduction band edge E_{C} under the gate shown in graph 410 in Fig. 1D to create potential wells in channel layers 109 and 105 in regions 105G1 and 109G1 of heterojunctions between layers 105 and 106 and between layers 109 and 110 shown in graph 510 of Fig. 2B. V1 also lowers conduction band E_{C} so that the newly created potential wells in regions 109G1 and 105G1 and the potential well shown in graph 410 in Fig. 1D in region 108G1 are at least partially below the Fermi energy E_{F}. The wells are therefore at least partially filled with electrons that populate 2DEGs in layers 105, 108 and 109 respectively. The 2DEGs and the electrons that fill them are represented by filled circles 105eG1, 108eG1 and 109eG1 n Fig. 2A and in the cross section of FET 20 shown in Fig. 2B.

Voltage V2 applied to gate G2 lowers conduction band E_{C} relative to its position in the OFF state of FET 20 shown in graph 420 of Fig. 1D so that as shown in graph 520 of Fig. 2B, potential wells in regions 109G2 and 108G2 of heterojunction between layer 109 and 110 and between layers 108 and 109 respectively are below the Fermi level. Voltage V2 also creates, or enhances, a potential well in region 105G2 under gate G2, which as shown in graph 520 of Fig. 2B is also below the Fermi level. The potential wells in layers 105, 108 and 109 are filled with 2DEGs, schematically represented by filled circles 105eG2, 108eG2 and 109eG2 respectively, in FET 20 shown in Fig. 2A and in the cross section of the FET in Fig. 2B. Negative voltage V3, operates to moderate fields and potential drops in the access region under gate G3 and prevent punch through to the drain.

As a result of the creation of 2DEGs under gate G1 in layers 105, 108 and 109 and the enhancement of 2DEGs in the access region under gate G2 in layers 108 and 109 and generation of 2DEGs in layer 105, a plurality of parallel 2DEG conducting current paths is provided between source SRC and drain DRN. The parallel current paths, shown as shaded regions 500 in layers 105, 106 and 109, "combine" to provide an enhanced 2DEG current path between the source and the drain characterized by a resistance lower than that of any of the component current paths. The combined current paths enable FET 20, when ON, to support a relatively large current between source SRC and drain DRN for a relatively small voltage drop between the source and drain and therefore a relatively moderate heat load.

In an embodiment of the invention FET 20 is characterized by an ON resistance between source SRC and drain DRN that is less than or equal to about 75 milliohms for a source SRC to drain DRN current of about 100 amps and voltage between the source and drain equal to about 1700 volts. Optionally the ON resistance is less than or equal to about 50 milliohms.

Relatively large quantities of hot electrons are generated in current channels between the source and drain of a FET when it is ON and conducting relatively large currents. A portion of the hot electrons propagate towards the FET drain and become trapped in surface states at an interface between a semiconductor channel layer carrying the current and a dielectric layer, such as dielectric layer 113 in FET 20, under the gate and drain access area and/or in traps in the dielectric layer and/or in a passivation layer, such as layer 112, under the drain. The trapped electrons generally damage the FET and degrade its operating parameters.

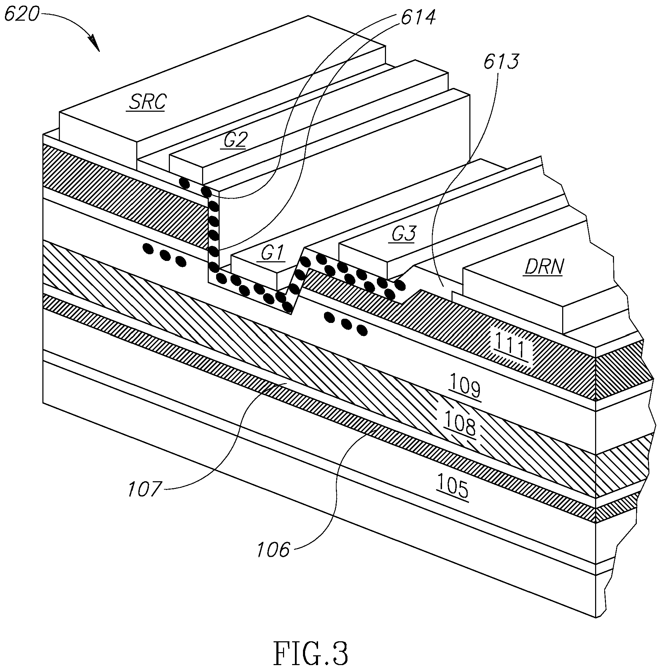

A FET, such as a FET similar to FET 20, in accordance with an embodiment of the invention may have a dielectric layer under its gates charged negatively optionally by embedding electrons in the layer plasma by enhanced chemical vapor deposition or atomic layer deposition. The negatively charge dielectric provides a repulsive electric field that operates as a barrier to hot electrons and reduces a probability of hot electrons being trapped at sensitive heterojunction surfaces. Fig. 3 schematically shows a portion of a FET 620 similar to FET 20 but having a dielectric layer 613 charged with electrons 614 that operate as a barrier to hot electrons, in accordance with an embodiment of the invention.

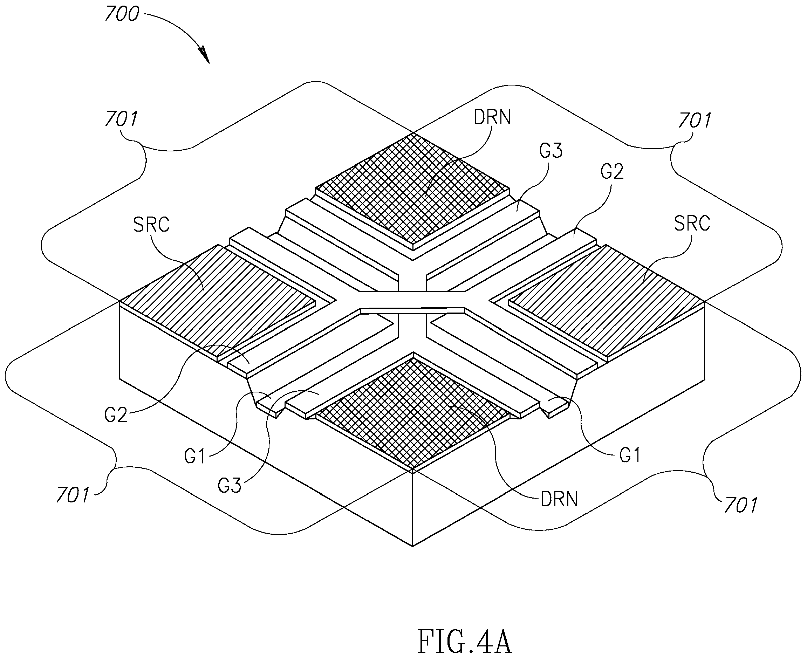

In an embodiment of the invention, a plurality of FETs, optionally similar to FET 20, are monolithically formed on a suitable substrate in a checkerboard array with each source, SRC of a FET adjacent at least two drains DRNs of other FETs in the array. Fig. 4A schematically shows a monolithically formed array 700 of FETs 701 for which the FETS are fabricated so that their sources SRC and drains DRNs form a checker board pattern. Optionally FETs 701 are similar to FET 20 and each FET 701 comprises three gates G1, G2 and G3. For convenience of presentation, semiconductor layers in the FETs under the drains and gates are not shown. Gates G1 for all the FETs, as shown in Fig. 4A, are electrically connected. Similarly, all gates G2 are electrically connected and all gates G3 are electrically connected. Electrical connections between the gates are optionally made at different levels in array 700 as schematically shown in Fig. 4A.

By growing FETs 701 in a checkerboard array, the gates have relatively large "active" perimeters for controlling 2DEG current channels between sources and drains compared to gates in a conventional array of FETs for which sources are adjacent each other, and a line of adjacent sources is opposite a line of adjacent drains. In general, a checkerboard array of FETs in accordance with an embodiment of the invention doubles the active perimeter of the gates in an array compared to a conventional array comprising the same number of FETs. Since ON resistance of a FET and an array of FETs is substantially proportional to active lengths of the gate perimeters, an array of FETs in accordance with an embodiment of the invention may have an ON resistance that is about half that of a conventional array. For a given current, the reduced ON resistance of a checkerboard array in accordance with an embodiment of the invention results in a substantially reduced heat load for the array compared to a conventional array. The checkerboard configuration also tends to moderate hot spots in the FET and foster a temperature distribution in the FET that is more uniform than temperature distributions in conventional arrays.

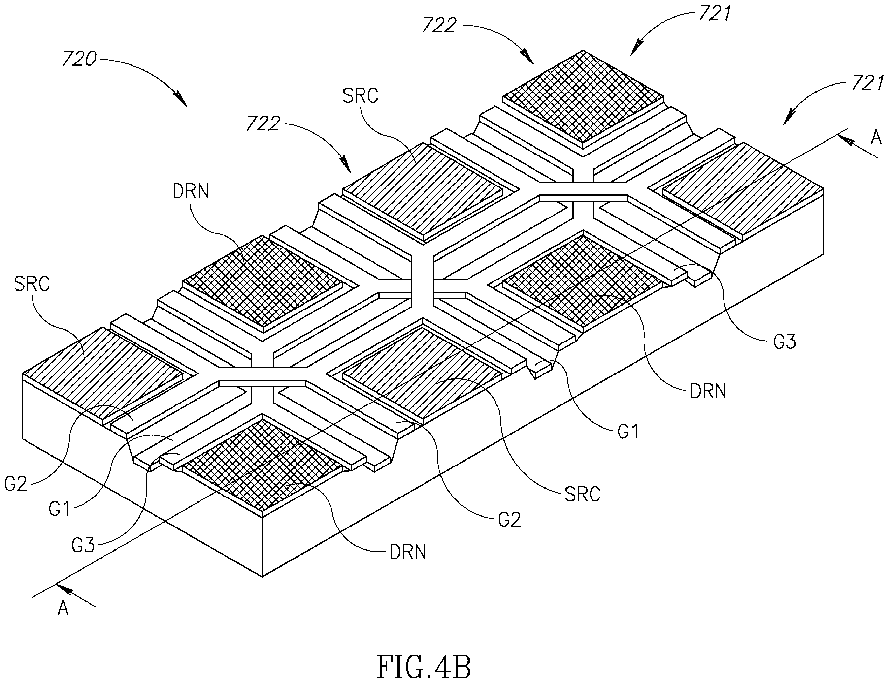

A checkerboard array, in accordance with an embodiment of the invention, is of course not limited to an array having two sources and two drains. For example, Fig. 4B schematically shows a checkerboard array 720 of FETs optionally similar to FET 20 (Fig. 1A) larger than array 700, in accordance with an embodiment of the invention. It is noted that whereas array 720 has a rectangular shape and comprises two rows 721 and four columns 722 of "interleaved" sources SRC and drains DRN, an array may have any number of rows and columns. For example, a checkerboard array of FETs in accordance with an embodiment of the invention may have a square shape and comprise a same number of rows and columns. In an embodiment of the invention a checkerboard FET array comprises 36 rows and 36 columns of FETs similar to FET 20 (Fig. 1A) and may support 50A of current.

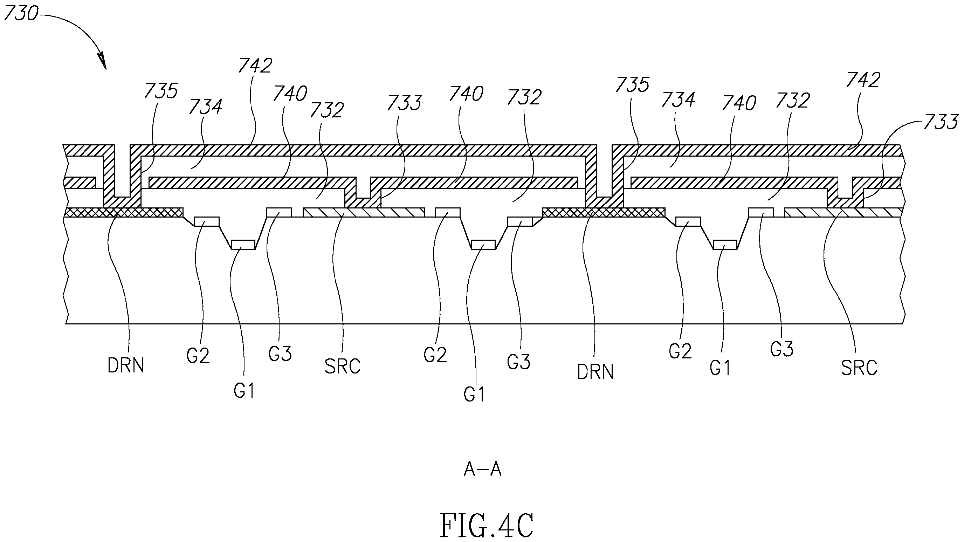

Fig. 4C shows a schematic cross section in a plane indicated by line AA of checkerboard array 720 shown in Fig. 4B that illustrates providing ohmic contacts to sources SRC and drains DRN of the array, in accordance with an embodiment of the invention. Ohmic contacts to sources SRC are optionally provided by a layer of metal 740 deposited over a layer of insulating material such as Si₃N₄, AL₂O₃, or A1N deposited to cover sources SRC, drains DRN and gates G1, G2, and G3. Metal layer 740 is also referred to as source pad 740. Electrical contacts between metal layer 740 and the various sources SRC are made by portions of metal layer 740 deposited in vias 733. An insulating layer 734 electrically isolates conducting layer 740 from a layer of metal 742, which provides ohmic contacts to drains DRN. Electrical contacts between metal layer 742 and the various sources SRC are made by portions of metal layer 740 that are deposited in vias 735. Metal in vias 735 are isolated from metal layer 74 by regions of insulating layer 734 and 732. Metal layer 742 is also referred to as drain pad 742.

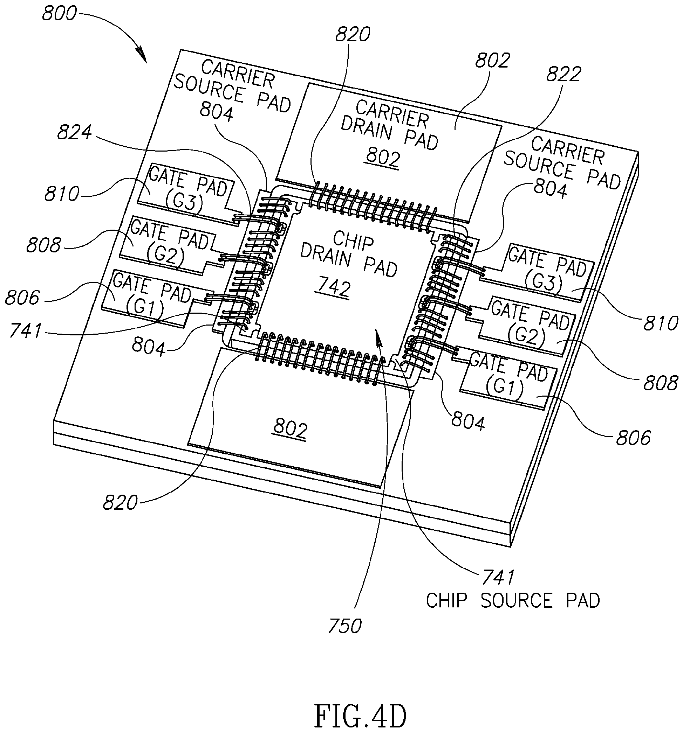

Fig. 4D schematically shows a FET checkerboard chip 750 comprising an optionally square checkerboard array of FETs mounted and electrically connected to a chip carrier 800 that provides electrical contacts for connecting chip 750 to a PCB, in accordance with an embodiment of the invention. Chip drain pad 742 that electrically connects, optionally as shown in Fig. 4C, drains DRN of FET checkerboard chip 750 may be connected to two carrier drain pads 802 comprised in chip carrier 800. Carrier drain pads 802 optionally lie along opposite edges of chip 750, and each carrier drain pad 802 is connected to chip drain pad 742 by a plurality of equally spaced, optionally A1, wire bonds 820 that are ball bonded to the chip and carrier drain pads. Chip source pad 741 (Fig. 4C) that connects all sources SRC in FET checkerboard chip 750 is connected, optionally, by ball bonded A1 wire bonds 822 to carrier source pads 804 located adjacent opposite edges of chip 750, which are perpendicular to the edges of the chip adjacent carrier drain pads 802. Gates G1, G2 and G3 of are electrically connected by wire bonds 824 to carrier gate pads 806, 808 and 810 respectively that are adjacent the same edges of chip 750 that are adjacent carrier source pads 804.

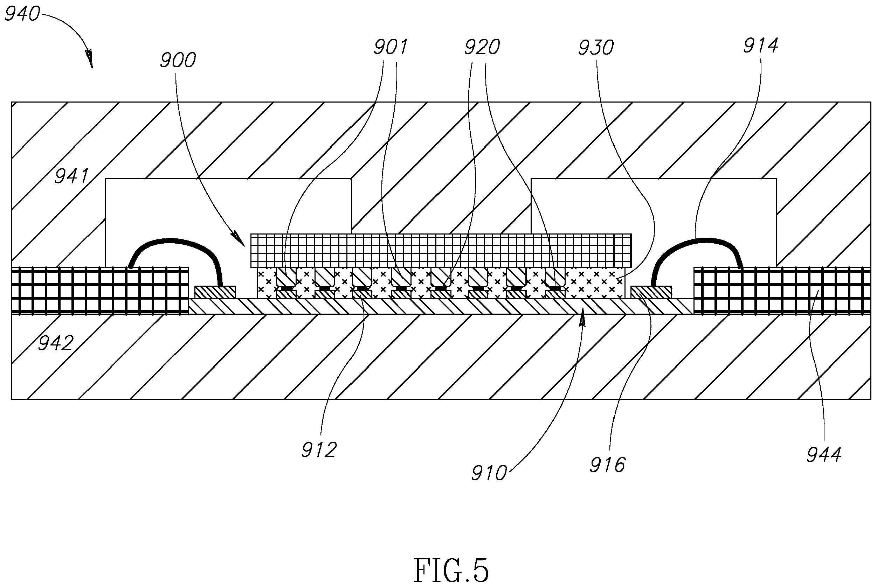

Fig. 5 schematically shows a cross section of a checkerboard FET chip 900 housed in a heat sink housing 940 comprising top and bottom heat sinks 941 and 942, in accordance with an embodiment of the invention.

Chip 900 is mounted and electrically connected to a ceramic interconnection substrate 910 that provides electrical contacts for electrically connecting chip 900 to a PCB (not shown). Connection between the chip and interconnection substrate is provided by a ball grid array of solder balls 920 optionally comprising a high temperature solder alloy such as AuSn. The solder balls are optionally formed on contact pads 901 in chip 900 that are electrically connected to gates G1, G2 and G3, and sources SRC and drains DRN (Figs. 4A, 4B) of the chip. The solder balls are soldered to corresponding homologous contact pads 912 comprised in interconnection substrate 910 to electrically connect the chip to the interconnect substrate. Optionally, the solder balls are first formed on contact pads 912 in substrate 910 and subsequently soldered to pads 901 in chip 900 to electrically connect the chip and the interconnect substrate. In Fig. 5 only contact pads 901 connected to sources SRC and drains DRN in chip 900 are shown. Lacunae between chip 900 and substrate 910 are optionally filled with a dielectric adhesive 930 that provides added mechanical stability to contact between the chip and substrate and improves electrical insulation between the solder balls.

Chip 900 and substrate 910 are sandwiched between upper and lower heat sinks 941 and 942 so that the heat sinks are in good thermal contact with the chip and the substrate. Electrical contact to ceramic interconnect substrate 910 from outside heat sink housing 940 is optionally provided by suitable connectors 944 that are wire bonded by wire bonds 914 to "peripheral" contact pads 916 comprised in the interconnect substrate.

In the description and claims of the present application, each of the verbs, "comprise" "include" and "have", and conjugates thereof, are used to indicate that the object or objects of the verb are not necessarily a complete listing of components, elements or parts of the subject or subjects of the verb.

Descriptions of embodiments of the invention in the present application are provided by way of example and are not intended to limit the scope of the invention. The described embodiments comprise different features, not all of which are required in all embodiments of the invention. Some embodiments utilize only some of the features or possible combinations of the features. Variations of embodiments of the invention that are described, and embodiments of the invention comprising different combinations of features noted in the described embodiments, will occur to persons of the art. The scope of the invention is limited only by the claims.

## Claims

1. A normally OFF field effect transistor (FET) comprising:
a plurality of contiguous nitride semiconductor layers; and
a source (SRC) and a drain (DRN) overlying a top nitride layer (112) of the plurality of nitride layers and having source and drain access regions respectively comprising regions of at least two heterojunctions between the nitride layers near the source and drain;
a first gate (G1) between the source (SRC) and drain (DRN); and
a set of nitride layers comprised in the plurality of nitride layers, the set comprising:
a first nitride layer (105) having a first band gap;
a second nitride layer (106) that forms a first said heterojunction with the first layer and having a second band gap wider than the first band gap and polarization that generates an electrostatic field (E106) in the second layer having a direction that causes electron drift towards the first heterojunction;
a third nitride layer (108) located on a same side of the first nitride layer as the second nitride layer having polarization that generates an electrostatic field (E108) in a direction opposite to the electric field in the second nitride layer which raises the conduction band at the first heterojunction under the first gate above the Fermi energy;
a fourth nitride layer (109) formed from GaN having band gap greater than the third layer that forms a second said heterojunction with the third layer having a two dimensional electron gas (2DEG) (108eG2, 108eG3) in the source and drain access regions but not in a region (108G1) below the first gate (G1) in the absence of a voltage applied to the first gate (Gl); and
a fifth nitride layer (111) formed from InAlGaN having band gap greater than the fourth nitride layer and polarization that generates an electrostatic field in the fifth nitride layer that causes electron drift towards the fourth layer and wherein the fourth nitride layer forms a third said heterojunction (109G2, 109G3) with the fifth nitride layer or with a nitride layer intermediate the fourth and fifth nitride layers that has a 2DEG (109eG2, 109eG3) in the source and drain access regions;
wherein the plurality of layers is formed having a recess (130) which extends into and has a recess surface (131) at the first gate (G1) in the fourth layer (109) that is covered by an insulating layer (113);
wherein a positive voltage applied to the first gate lowers the conduction band at the first heterojunction in a region under the first gate, to generate a plurality of parallel 2DEGs (105eG1, 108eG1, 109eG1) which couple the two 2DEGs (108eG2, 108eG3, 109eG2, 109eG3) in each of the access regions with a conducting channel through the plurality of nitride layers to form a continuous electrically conducting path between the source and drain that turns the FET ON.

2. A FET according to claim 1 wherein the second layer comprises In_{y}Al_{z}Ga_{1-y-z}N.

3. A FET according to claim 2 wherein the In_{y}Al_{z}Ga_{1-y-z}N layer has thickness between about 8 nm and about 12 nm.

4. A FET according to any of claim 1-3 wherein the third layer is above, and thereby closer to the source and drain, than the first and second layers.

5. A FET according to claim to any of claims 1-4 wherein the third layer comprises InₓGa₁₋ₓN.

6. A FET according to claim 5 wherein x has a value between about 0.08 and about 0.11.

7. A FET according to any of the preceding claims wherein the insulating layer is negatively charged.

8. A FET according to any of the preceding claims wherein the fourth layer on either side of the recess has thickness between about 1 nm and about 17 nm.

9. A FET according to any of the preceding claims and comprising second and third gates (G2, G3) on opposite sides of the first gate (G1) that respectively overlie access regions of the source (SRC) and drain (DRN) at the fifth nitride layer.

10. A FET according to claim 9 wherein the plurality of contiguous nitride layers is formed having a recess that extends into and has a recess surface located in the fifth nitride layer.

11. A FET according to claim 10 wherein the third gate is located on an insulating layer covering the recess surface in the fifth nitride layer.

12. A FET according to claim 11 wherein the insulating layer is negatively charged.

13. A FET according to any of claims 9-12 and comprising a power supply that applies voltages V1, V2, and V3, to the first, second, and third gates (G1, G2, G3) respectively when turning the FET ON, wherein the voltages are related by a relationship V2 > V1 > V3.

## Patentansprüche

1. Selbstsperrender Feldeffekttransistor (FET), umfassend:
eine Vielzahl zusammenhängender Nitridhalbleiterschichten; und
eine Source (SRC) und einen Drain (DRN), die über einer oberen Nitridschicht (112) der Vielzahl der Nitridschichten liegen und Source- und Drain-Zugriffsbereiche aufweisen, die jeweils Bereiche von mindestens zwei Heteroübergängen zwischen den Nitridschichten nahe der Source und dem Drain umfassen;
ein erstes Gate (G1) zwischen der Source (SRC) und dem Drain (DRN); und
einen Satz Nitridschichten, der in der Vielzahl der Nitridschichten enthalten ist, wobei der Satz Folgendes umfasst:
eine erste Nitridschicht (105) mit einer ersten Bandlücke;
eine zweite Nitridschicht (106), die einen ersten der Heteroübergänge mit der ersten Schicht bildet, mit einer zweiten Bandlücke, die breiter als die erste Bandlücke ist, und einer Polarisation, die ein elektrostatisches Feld (E106) in der zweiten Schicht erzeugt, mit einer Richtung, die einen Elektronendrift in Richtung des ersten Heteroübergangs bewirkt;
eine dritte Nitridschicht (108), die sich auf einer selben Seite der ersten Nitridschicht wie die zweite Nitridschicht befindet, und mit einer Polarisation, die ein elektrostatisches Feld (E108) in einer Richtung entgegengesetzt zu dem elektrischen Feld in der zweiten Nitridschicht erzeugt, welches das Leitungsband am ersten Heteroübergang unter dem ersten Gate über die Fermi-Energie anhebt;
eine vierte Nitridschicht (109), die aus GaN gebildet ist, mit einer Bandlücke, die größer ist als die dritte Schicht, die einen zweiten Heteroübergang mit der dritten Schicht bildet und mit einem zweidimensionalen Elektronengas (2DEG) (108eG2, 108eG3) in den Source- und Drain-Zugriffsbereichen jedoch nicht in einem Bereich (108G1) unterhalb des ersten Gate (G1), wenn an dem erste Gate (G1) keine Spannung angelegt ist; und
eine fünfte Nitridschicht (111), die aus InAlGaN gebildet ist, mit einer Bandlücke, die größer ist als die vierte Nitridschicht und einer Polarisation, die ein elektrostatisches Feld in der fünften Nitridschicht erzeugt, das einen Elektronendrift in Richtung der vierten Schicht bewirkt und wobei die vierte Nitridschicht einen dritten der Heteroübergänge (109G2, 109G3) mit der fünften Nitridschicht oder mit einer Nitridschicht zwischen der vierten und fünften Nitridschicht bildet, die ein 2DEG (109eG2, 109eG3) in den Source- und Drain-Zugriffsbereichen aufweist;
wobei die Vielzahl der Schichten mit einer Vertiefung (130) gebildet ist, die sich in das erste Gate in der vierten Schicht (109), die von einer Isolierschicht (113) bedeckt ist, erstreckt und dort eine Vertiefungsfläche (131) aufweist;
wobei eine an das erste Gate angelegte positive Spannung das Leitungsband an dem ersten Heteroübergang in einem Bereich unter dem ersten Gate senkt, um eine Vielzahl paralleler 2DEGs (105eG1, 108eG1, 109eG1) zu erzeugen, die die beiden 2DEGs (108eG2, 108eG3, 109eG2), 109eG3) in jedem der Zugriffsbereiche durch die Vielzahl von Nitridschichten mit einem leitenden Kanal koppeln, um einen kontinuierlichen elektrisch leitenden Pfad zwischen der Source und dem Drain zu bilden, der den FET auf EIN schaltet.

2. FET nach Anspruch 1, wobei die zweite Schicht In_{y}Al_{z}Ga_{1-y-z}N umfasst.

3. FET nach Anspruch 2, wobei die In_{y}Al_{z}Ga_{1-y-z}N-Schicht eine Dicke zwischen etwa 8 nm und etwa 12 nm aufweist.

4. FET nach einem der Ansprüche 1 bis 3, wobei die dritte Schicht oberhalb und damit näher an der Source und dem Drain liegt als die erste und die zweite Schicht.

5. FET nach einem der Ansprüche 1 bis 4, wobei die dritte Schicht InₓGa₁₋ₓN umfasst.

6. FET nach Anspruch 5, wobei x einen Wert zwischen etwa 0,08 und etwa 0,11 aufweist.

7. FET nach einem der vorhergehenden Ansprüche, wobei die Isolierschicht negativ geladen ist.

8. FET nach einem der vorhergehenden Ansprüche, wobei die vierte Schicht auf beiden Seiten der Vertiefung eine Dicke zwischen etwa 1 nm und etwa 17 nm aufweist.

9. FET nach einem der vorhergehenden Ansprüche und umfassend zweite und dritte Gates (G2, G3) auf gegenüberliegenden Seiten des ersten Gate (G1), die jeweils über Zugriffsbereichen der Quelle (SRC) und des Drain (DRN) an der fünften Nitridschicht liegen.

10. FET nach Anspruch 9, wobei die Vielzahl von zusammenhängenden Nitridschichten mit einer Vertiefung gebildet ist, die sich in die fünfte Nitridschicht erstreckt und eine dort befindliche Vertiefungsfläche aufweist.

11. FET nach Anspruch 10, wobei sich das dritte Gate auf einer Isolierschicht befindet, die die Vertiefungsfläche in der fünften Nitridschicht bedeckt.

12. FET nach Anspruch 11, wobei die Isolierschicht negativ geladen ist.

13. FET nach einem der Ansprüche 9-12 und umfassend eine Stromzufuhr, die die Spannungen V1, V2 und V3 jeweils am ersten, zweiten und dritten Gate (G1, G2, G3) anlegt, wenn der FET auf EIN geschaltet wird, wobei die Spannungen durch eine Beziehung V2 > V1 > V3 miteinander verknüpft sind.

## Revendications

1. Transistor à effet de champ (TEC) normalement hors tension, comprenant :
une pluralité de couches semi-conductrices de nitrure contiguës ; et
une source (SRC) et un drain (DRN) recouvrant une couche de nitrure supérieure (112) parmi la pluralité de couches de nitrure et ayant des régions d'accès à la source et au drain, comprenant respectivement des régions d'au moins deux hétérojonctions entre les couches de nitrure près de la source et du drain ;
une première grille (G1) entre la source (SRC) et le drain (DRN) ; et
un ensemble de couches de nitrure comprises dans la pluralité de couches de nitrure, l'ensemble comprenant :
une première couche de nitrure (105) ayant une première bande interdite ;
une deuxième couche de nitrure (106) qui forme une première hétérojonction précitée avec la première couche et ayant une deuxième bande interdite plus large que la première bande interdite, et une polarisation qui génère un champ électrostatique (E106) dans la deuxième couche, ayant une direction qui provoque un courant d'électrons en direction de la première hétérojonction ;
une troisième couche de nitrure (108) située du même côté de la première couche de nitrure que la deuxième couche de nitrure, ayant une polarisation qui génère un champ électrostatique (E108) dans une direction opposée au champ électrique dans la deuxième couche de nitrure, qui élève la bande de conduction, au niveau de la première hétérojonction sous la première grille, au-dessus de l'énergie de Fermi ;
une quatrième couche de nitrure (109) formée de GaN ayant une bande interdite plus grande que la troisième couche qui forme une deuxième hétérojonction précitée avec la troisième couche, ayant un gaz d'électrons bidimensionnel (2DEG) (108eG2, 108eG3) dans les régions d'accès à la source et au drain, mais pas dans une région (108G1) en dessous de la première grille (G1) en l'absence d'une tension appliquée à la première grille (G2) ; et
une cinquième couche de nitrure (111) formée d'InAlGaN, ayant une bande interdite plus grande que la quatrième couche de nitrure et une polarisation qui génère un champ électrostatique dans la cinquième couche de nitrure, qui provoque un courant d'électrons en direction de la quatrième couche et dans lequel la quatrième couche de nitrure forme une troisième hétérojonction précitée (109G2, 109G3) avec la cinquième couche de nitrure ou avec une couche de nitrure intermédiaire entre les quatrième et cinquième couches de nitrure, qui a un 2DEG (109eG2, 109eG3) dans les régions d'accès à la source et au drain ;
dans lequel la pluralité de couches est formée, présentant un évidement (130) qui s'étend dans, et présente une surface d'évidement (131) au niveau de la première grille (G1) dans la quatrième couche (109) qui est couverte par une couche isolante (113) ;
dans lequel une tension positive appliquée à la première grille abaisse la bande de conduction au niveau de la première hétérojonction dans une région sous la première grille, pour générer une pluralité de 2DEG parallèles (105eG1, 108eG1, 109eG1) qui couplent les deux 2DEG (108eG2, 108eG3, 109eG2, 109eG3) dans chacune des régions d'accès avec un canal conducteur à travers la pluralité de couches de nitrure pour former une trajectoire électriquement conductrice continue entre la source et le drain, laquelle met le TEC sous tension.

2. TEC selon la revendication 1, dans lequel la deuxième couche comprend In_{y}Al_{z}Ga_{1-y-z}N.

3. TEC selon la revendication 2, dans lequel la couche d'In_{y}Al_{z}Ga_{1-y-z}N a une épaisseur comprise entre environ 8 nm et environ 12 nm.

4. TEC selon l'une quelconque des revendications 1 à 3, dans lequel la troisième couche est au-dessus, et de ce fait plus près de la source et du drain que les première et deuxième couches.

5. TEC selon l'une quelconque des revendications 1 à 4, dans lequel la troisième couche comprend InₓGa₁₋ₓN.

6. TEC selon la revendication 5, dans lequel x a une valeur comprise entre environ 0,08 et environ 0,11.

7. TEC selon l'une quelconque des revendications précédentes, dans lequel la couche isolante est chargée négativement.

8. TEC selon l'une quelconque des revendications précédentes, dans lequel la quatrième couche de chaque côté de l'évidement a une épaisseur comprise entre environ 1 nm et environ 17 nm.

9. TEC selon l'une quelconque des revendications précédentes et comprenant des deuxième et troisième grilles (G2, G3) sur des côtés opposés de la première grille (G1) qui recouvrent respectivement les régions d'accès de la source (SRC) et du drain (DRN) au niveau de la cinquième couche de nitrure.

10. TEC selon la revendication 9, dans lequel la pluralité de couches de nitrure contiguës est formée, présentant un évidement qui s'étend, et possède une surface d'évidement située, dans la cinquième couche de nitrure.

11. TEC selon la revendication 10, dans lequel la troisième grille est située sur une couche d'isolation couvrant la surface d'évidement dans la cinquième couche de nitrure.

12. TEC selon la revendication 11, dans lequel la couche isolante est chargée négativement.

13. TEC selon l'une quelconque des revendications 9 à 12 et comprenant une alimentation électrique qui applique des tensions V1, V2 et V3, aux première, deuxième et troisième grilles (G1, G2, G3) respectivement lorsque l'on met le TEC sous tension, dans lequel les tensions sont liées par une relation V2 > V1 > V3.
